Europäisches Patentamt

European Patent Office

Office européen des brevets

(19)

(11) Numéro de publication: **0 356 273 B1**

(12)

# FASCICULE DE BREVET EUROPEEN

(45) Date de publication de fascicule du brevet: **03.11.93** (51) Int. Cl.5: **G01R 15/07**, G01R 19/32

(21) Numéro de dépôt: **89402064.3**

(22) Date de dépôt: **20.07.89**

(54) Dispositif à capteurs optiques principal et secondaire.

(30) Priorité: **21.07.88 FR 8809873**

(43) Date de publication de la demande:
**28.02.90 Bulletin   90/09**

(45) Mention de la délivrance du brevet:
**03.11.93 Bulletin   93/44**

(84) Etats contractants désignés:
**CH DE FR GB LI SE**

(56) Documents cités:
**EP-A- 0 083 196**
**GB-A- 2 068 137**
**GB-A- 2 164 146**

**PATENT ABSTRACTS OF JAPAN, vol. 7, no. 32 (P-174)[1177], 8 février 1983; & JP-A-57 184 974**

**REVUE GENERALE DE L'ELECTRICITE, no. 6, juin 1986, pages 24-29, Paris FR; P. MEY-RUEIX et al.: "Capteur de courant à effet Faraday: un prototype performant à fibre op-tique monomode"**

(73) Titulaire: **GEC ALSTHOM PROTECTION & CONTROLE**
**50, avenue Jean-Jaurès**
**F-92120 Montrouge(FR)**

(72) Inventeur: **Meyrueix, Paul**
**125 rue Raymond Losserand**
**F-75014 Paris(FR)**
Inventeur: **Chatrefou, Denis**
**62 rue de Boussy**
**F-91800 Epinay Sur Senart(FR)**
Inventeur: **Simon, Jean**
**30 rue de Charenton**
**F-75012 Paris(FR)**

(74) Mandataire: **Weinmiller, Jürgen, Dipl.-Ing. et al**
**SPOTT, WEINMILLER & PARTNER,**
**Postfach 24**
**D-82336 Feldafing (DE)**

## Description

La présente invention concerne un dispositif pour la mesure d'un paramètre physique évolutif, comprenant: des moyens d'émission de lumière propres à produire au moins un faisceau lumineux excitateur; un premier capteur optique, soumis à l'influence dudit paramètre physique, recevant au moins un faisceau excitateur, et produisant au moins un faisceau modifié correspondant, dont l'état de polarisation dépend de la valeur dudit paramètre physique; et des moyens de détection recevant au moins un faisceau modifié issu dudit premier capteur et produisant au moins un signal électrique principal dépendant dudit paramètre.

Des dispositifs de ce type sont bien connus dans de nombreuses applications, notamment pour la mesure de tensions électriques alternatives.

Quel que soit le paramètre physique mesuré, il arrive très souvent que des effets perturbateurs, tels que la température, interviennent dans la mesure, soit que ces perturbations agissent sur le paramètre en question dans une proportion qu'il est important de connaître, soit qu'elles faussent la mesure, qu'il convient donc de corriger.

Dans tous les cas, une solution consiste à disposer d'un capteur secondaire, par exemple un capteur de température, propre à fournir l'information supplémentaire que représente la valeur de cette dernière.

Lorsque le premier capteur, conçu pour mesurer le paramètre physique principal, est de type optique, il peut être a priori envisagé d'utiliser, pour la mesure de la perturbation, un capteur qui soit aussi de type optique.

Cette approche conduit cependant à un montage généralement trop complexe pour être mis en oeuvre dans la mesure où, notamment dans le cas de la température, les évolutions de la perturbation ayant une fréquence le plus souvent très basse, le capteur secondaire, le thermomètre optique par exemple, doit être doté d'une source de lumière modulée en polarisation ou phase, alors que pour le premier capteur affecté à la mesure du paramètre physique principal, l'emploi d'une Source de lumière continue suffit généralement.

Dans ce contexte, le but de la présente invention est de proposer un dispositif combinant un capteur optique principal pour la mesure d'un paramètre évolutif et un capteur optique secondaire pour la mesure de la perturbation, et dans lequel aucune source de lumière particulière n'est prévue pour ce second capteur.

Il est en outre connu, du document Patent Abstracts of Japan, vol. 7, n° 32 (P-174) [1177], 8 février 1983 & JP-A- 57 184 974 un montage comportant, pour une mesure de température, un capteur de type optique. Cependant pour fournir une indication de la température, ce montage utilise un faisceau qui ne traverse pas le capteur soumis au paramètre physique à mesurer, voir la figure 3 de JP-A- 57 184 974.

Le dispositif de l'invention, qui est destiné à permettre la mesure d'un paramètre physique évolutif, et qui comprend: des moyens d'émission de lumière propres à produire au moins un faisceau lumineux excitateur; un premier capteur optique, soumis à l'influence dudit paramètre physique, recevant au moins un faisceau excitateur, et produisant au moins un faisceau modifié correspondant, dont l'état de polarisation dépend de la valeur dudit paramètre physique; et des moyens de détection recevant au moins un faisceau modifié issu dudit premier capteur et produisant au moins un signal électrique principal dépendant dudit paramètre, est essentiellement caractérisé en ce qu'il comprend un séparateur de faisceaux grâce auquel deux faisceaux modifés sont rendus disponibles, et en ce qu'il comprend en outre un second capteur optique, sensible à une perturbation et soumis à des variations de cette perturbation qui, si elles existent, sont plus lentes que celles dudit paramètre physique, ce second capteur recevant l'un des deux faisceaux modifiés et produisant un faisceau deux fois modifié, dont l'état de polarisation dépend dudit paramètre et de la perturbation, en ce que lesdits moyens de détection comprennent des moyens additionnels pour détecter ledit faisceau deux fois modifié et pour produire un signal électrique additionnel dépendant dudit paramètre et de la perturbation, et en ce que ce dispositif comprend en outre des moyens de traitement pour extraire, grâce aux différences entre lesdits signaux principal et additionnel, un signal représentatif de la perturbation.

Ce dispositif est notamment utilisable lorsque le premier capteur présente une sensibilité indésirable à la perturbation, par exemple la température; dans ce cas, les premier et second capteurs sont placés dans un même environnement vis-à-vis de la perturbation, par exemple dans un même environnement thermique, et les moyens de traitement comprennent des moyens pour combiner le signal représentatif de la perturbation, de la température par exemple, au moins avec le signal principal ou avec un signal qui en est dérivé, pour fournir un signal corrigé représentatif dudit paramètre physique.

Suivant un mode de réalisation simple, le second capteur peut comprendre une lame biréfringente dont la biréfringence dépend de la perturbation.

Une application possible d'un dispositif selon l'invention est celle dans laquelle le paramètre physique est une tension alternative.

Dans ce cas, le premier capteur comprend avantageusement un cristal de germanate de bismuth $Bi_4Ge_3O_{12}$ présentant une forme allongée terminée par deux faces planes recouvertes d'électrodes respectives; l'une au moins des électrodes est transparente pour permettre le passage de la lumière, et la tension alternative à mesurer est directement appliquée sur ces électrodes.

De plus, il peut alors être souhaitable, notamment pour une plus grande immunité aux perturbations, que le cristal soit orienté de manière que son axe cristallographique (0, 0, 1) soit parallèle à la direction de l'un au moins des faisceaux excitateurs.

D'autres caractéristiques et avantages de l'invention ressortiront clairement de la description qui en est faite ci-après à titre indicatif en référence aux dessins annexés, parmi lesquels:

- La figure 1 est un schéma représentant la partie optique d'un dispositif conforme à l'invention; et
- La figure 2 est un schéma représentant un circuit de traitement pour un dispositif conforme à l'invention.

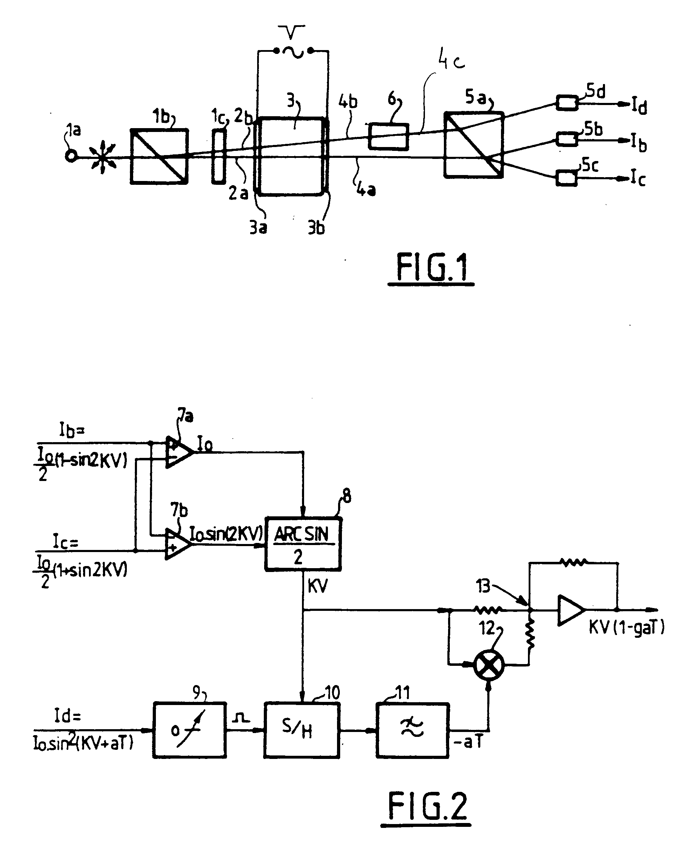

Le dispositif représenté sur la figure 1 est destiné à la mesure d'un paramètre physique évolutif, tel qu'une tension alternative V.

Ce dispositif comprend tout d'abord des moyens d'émission de lumière, constitués d'une source lumineuse 1a, d'un polariseur de Rochon 1b, et d'une lame quart d'onde 1c; la source est conçue pour produire une lumière dépolarisée, que le polariseur de Rochon sépare en deux faisceaux linéairement polarisés; la lame quart d'onde, dont les axes font un angle de 45 degrés avec ceux du polariseur 1b, n'a pour fonction que de transformer l'état de polarisation linéaire des faisceaux issus du polariseur 1b en un état de polarisation circulaire, la nécessité de prévoir une telle lame étant donc liée au type particulier de capteur optique utilisé dans le dispositif; en l'occurrence, l'ensemble des éléments 1a à 1c produit donc deux faisceaux lumineux excitateurs à polarisation circulaire 2a et 2b.

Le dispositif comprend ensuite un capteur optique 3, soumis à l'influence de la tension électrique alternative V, laquelle constitue un paramètre physique évolutif, c'est-à-dire une grandeur physique variable dont le spectre de fréquences comprend des fréquences non nulles, par exemple une raie unique à 50 Hz.

Le capteur optique 3 est par exemple constitué par un cristal électro-optique à effet Pockels, tel qu'un cristal de germanate de bismuth $Bi_4Ge_3O_{12}$. Ce cristal isotrope sans champ appliqué, devient anisotrope (biréfrégence linéaire) sous l'influence d'un champ appliqué; dans la configuration décrite, ses axes optiques ont même direction que ceux de la lame quart d'onde 1c.

Ce cristal présente une forme allongée et est terminé par deux faces planes recouvertes d'électrodes transparentes respectives 3a et 3b, sur lesquelles est directement appliquée la tension alternative V à mesurer.

Le capteur optique 3 reçoit, par sa face recouverte de l'électrode 3a, les faisceaux excitateurs 2a et 2b, lesquels traversent ce capteur et en ressortent par la face recouverte de l'électrode 3b, sous la forme de faisceaux modifiés correspondants 4a et 4b, dont l'état de polarisation à chaque instant dépend de la valeur de la tension V.

Le dispositif comprend en outre des moyens de détection principaux, consistant de préférence en un analyseur de Wollaston 5a et en deux photorécepteurs, deux photodiodes 5b et 5c par exemple.

L'analyseur 5a est orienté de manière que ses axes optiques aient même direction que les axes propres du cristal sous tension; cet analyseur sépare les composantes orthogonales du faisceau modifié 4a (conventionnellement appelé ici "faisceau principal"), dont les intensités respectives sont détectées par les diodes 5b et 5c, qui en fournissent des images sous la forme de signaux électriques $I_b$ et $I_c$ correspondants. Par convention, ces signaux seront collectivement considérés comme constituant le "signal principal", chacun de ces signaux constituant une composante de ce signal principal.

A ceci près que le polariseur 1b utilisé joue le rôle de séparateur de faisceaux et fournit deux faisceaux excitateurs 2a et 2b, et que le capteur 3 est un cristal de germanate de bismuth directement soumis à l'influence du paramètre à mesurer, le montage décrit jusqu'à présent est un montage polarimétrique classique, connu pour permettre la mesure d'une tension, par exemple d'une tension alternative V.

Cependant, la mise en oeuvre d'un tel dispositif par exemple dans un environnement susceptible de connaître des variations de température importantes se heurte au problème d'une dépendance en température de la sensibilité du capteur, du cristal de germanate de bismuth en l'occurrence, de sorte que l'état de polarisation du faisceau modifié principal 4a, idéalement représentatif de la tension V, varie également avec la température.

Pour tenir compte de ce phénomène et en corriger les effets, il est prévu, conformément à l'invention, un second capteur optique 6, sensible à la température, placé sur le trajet de l'autre faisceau modifié 4b, dit "faisceau secondaire", et produisant un faisceau deux fois modifié 4c, dont l'état de polarisation dépend de la tension V et de la température de ce second capteur optique.

Dans la mesure où ce second capteur optique, par exemple constitué par une lame biréfringente telle qu'une lame de quartz, modifie l'état de polarisation du faisceau 4b d'une façon qui dépend de la température, les dépendances en température des états de polarisation des faisceaux 4a et 4c sont nécessairement différentes; en effet, même s'il existe une température ou une gamme donnée de températures pour lesquelles le second capteur reste inactif, les faisceaux 4a et 4c ne pourront présenter le même état de polarisation que pour cette température ou cette gamme.

En raison de sa double dépendance, le faisceau 4c est modulé en fonction de la valeur du paramètre à mesurer, de la tension V en l'occurrence; l'invention utilise donc le capteur 3 soumis à l'influence du paramètre physique à mesurer comme un modulateur de lumière, ce qui d'une part autorise à ne disposer que d'une seule source 1a et d'autre part rend superflue la présence d'un modulateur supplémentaire; en contrepartie, l'efficacité du dispositif est limitée au cas où le second capteur optique 6 est soumis à des variations de température plus lentes que celles du paramètre physique, cette condition étant cependant aisément vérifiée dans le cas où le paramètre mesuré est une tension alternative de 50 Hz.

Comme le comprendra aisément l'homme de l'art, le séparateur de faisceaux aurait pu consister, au lieu d'un polariseur de Rochon, en une lame semi-transparente disposée sur le trajet du faisceau modifié 4a et propre à faire apparaître le faisceau secondaire 4b.

En plus de l'analyseur 5a et des diodes 5b et 5c, les moyens de détection comprennent une diode additionnelle 5d prévue pour détecter le faisceau deux fois modifié 4c ayant traversé l'analyseur 5a, et pour produire un signal électrique additionnel $I_d$ dépendant du paramètre physique mesuré et de la température.

Le dispositif comprend en outre des moyens de traitement, dont un mode de réalisation possible sera détaillé en référence à la figure 2, et qui permettent d'extraire, grâce aux différences entre le signal principal $I_b$ et/ou $I_c$ et le signal additionnel $I_d$, un signal représentatif de la température du second capteur optique.

Cette technique présente notamment un intérêt considérable lorsque le premier capteur 3 présente une sensibilité indésirable à la température, ce qui est effectivement le cas des capteurs à effets Pockels.

Dans ce cas en effet, sous réserve de placer les premier et second capteurs dans un même environnement thermique, il devient possible, en combinant le signal représentatif de la température au moins avec le signal principal ou avec un signal qui en est dérivé, d'obtenir un signal représentatif du paramètre mesuré et corrigé des effets parasites de la température.

L'invention permet ainsi la réalisation d'un capteur de tension à effet Pockels d'une grande précision.

Dans un tel dispositif, le capteur 3, avantageusement constitué par un cristal de germanate de bismuth en dépit de la dépendance de ce cristal en température, est de préférence orienté de manière que son axe cristallographique (0, 0, 1) soit parallèle à la direction de l'un au moins des faisceaux excitateurs, par exemple du faisceau 4a, cette disposition permettant notamment d'obtenir un capteur rigoureusement sensible à la tension V quelles que soient les perturbations électriqueS externes, et dont la sensibilité soit indépendante de la géométrie du cristal utilisé.

La figure 2 est un schéma d'un circuit de traitement pour un capteur de tension alternative à effet Pockels, utilisant un cristal de germanate de bismuth compensé en température conformément à l'enseignement de la présente invention.

Ce circuit de traitement reçoit les première et seconde composantes $I_b$ et $I_c$ du signal principal, ainsi que le signal additionnel $I_d$, respectivement produits par les photodétecteurs 5b, 5c, et 5d.

Les valeurs de ces signaux sont données par les expressions suivantes:

$$I_b = (I_o/2).(1-\sin 2K.V);$$
$$I_c = (I_o/2).(1+\sin 2K.V) \text{ et}$$
$$I_d = I_o.\sin^2(K.V + a.T),$$

expressions dans lesquelles $I_o$ est une grandeur liée à l'intensité de la source 1a, dans lesquelles K et a sont deux constantes de proportionnalité dont la première dépend du premier capteur optique 3 et la seconde du second capteur 6, dans lesquelles V est la valeur instantanée de la tension alternative à mesurer, et dans lesquelles T est la valeur de la différence entre la température des capteurs 3 et 6 et la température pour laquelle le déphasage introduit par le capteur 6 est égal à 45 degrés.

De préférence, la température moyenne représentant les conditions normales de fonctionnement du dispositif est choisie comme la température pour laquelle T est nulle.

Les signaux $I_b$ et $I_c$ parviennent à deux amplificateurs dont le premier 7a produit un signal représentatif de leur somme $I_o$, et dont le second 7b produit un signal représentatif de leur différence $I_o.\sin(2.K.V)$.

Ces signaux de somme et de différence sont fournis à un générateur de fonction 8 qui produit un signal de sortie représentatif de la moitié de l'arc-sinus du rapport du signal différence au signal somme, autrement dit de K.V.

Le signal additionnel $I_d$ parvient à un détecteur de passage à zéro 9 qui, à chaque passage à zéro du signal additionnel $I_d$, commande un échantillonneur-bloqueur 10 recevant le signal représentatif de K.V.

La somme K.V + a.T étant nulle à l'instant du passage à zéro de $I_d$, le signal mémorisé dans l'échantillonneur-bloqueur 10 est représentatif de -a.T.

Le signal -a.T de sortie de l'échantillonneur-bloqueur 10, filtré par un filtre passe-bas 11, est appliqué à une entrée d'un multiplieur analogique à quatre quadrants 12 dont une autre entrée reçoit le signal K.V issu du générateur de fonction 8.

Le signal de sortie -a.T.K.V du multiplieur 12, soumis à une amplification de gain g par un amplificateur 13, est, par ce même amplificateur, additionné au signal de sortie du générateur 8, le signal de sortie de l'amplificateur 13 étant ainsi représentatif de la grandeur K.V - g.a.T.K.V.

En fait, ce signal de sortie constitue la version corrigée en température du signal K.V, cette correction résultant des effets suivants.

La variation en température de la sensibilité du capteur 3 se traduit globalement par une variation du paramètre de montage K qui, au lieu de conserver une valeur fixe $K_o$, prend une valeur $K = K_o.(1 + b.T)$, où b est une constante connue ou aisément mesurable, dépendant du matériau constituant le capteur 3.

Le gain g est choisi de manière que $g = b/a$, ce dont il résulte que le signal de sortie de l'amplificateur 13, représentatif de K.V - g.a.T.K.V, est aussi représentatif de $K_o.V.(1 - b^2.T^2)$. Or, dans la mesure où la grandeur $b^2.T^2$ est très petite, le signal de sortie de l'amplificateur 13 peut être considéré comme représentatif de $K_o.V$ quelle que soit la température correspondant à T.

**Revendications**

1. Dispositif pour la mesure d'un paramètre physique évolutif, comprenant : des moyens (1a) d'émission de lumière propres à produire au moins un faisceau lumineux excitateur; un premier capteur optique (3), soumis à l'influence dudit paramètre physique, recevant au moins un faisceau excitateur (2a), et produisant au moins un faisceau modifié correspondant (4a) dont l'état de polarisation dépend de la valeur dudit paramètre physique; et des moyens de détection (5a, 5b, 5c) recevant au moins un faisceau modifié issu dudit premier capteur et produisant au moins un signal électrique principal (Ib, Ic) dépendant dudit paramètre, caractérisé en ce qu'il comprend un séparateur de faisceaux (1b) grâce auquel sont disponibles deux faisceaux modifiés (4a, 4b), en ce qu'il comprend en outre un second capteur optique (6), sensible à une perturbation et soumis à des variations de cette perturbation qui, si elles existent, sont plus lentes que celles dudit paramètre physique, ce second capteur recevant l'un (4b) des deux faisceaux modifiés et, pour la gamme de valeurs de ladite perturbation pour laquelle ledit second capteur est actif, ce second capteur produisant un faisceau deux fois modifié (4c) dont l'état de polarisation dépend dudit paramètre et de la perturbation, en ce que lesdits moyens de détection comprennent des moyens additionnels (5d) pour détecter ledit faisceau deux fois modifié et pour produire un signal électrique additionnel (Id) dépendant dudit paramètre et de la perturbation, et en ce que ce dispositif comprend en outre des moyens de traitement (7a, 7b, 8, 9, 10, 11, 12, 13) pour extraire, grâce aux différences entre lesdits signaux principal et additionnel, un signal représentatif de la perturbation.

2. Dispositif suivant la revendication 1, caractérisé en ce que ledit premier capteur (3) présente une sensibilité indésirable à ladite perturbation, en ce que lesdits premier (3) et second (6) capteurs sont placés dans un même environnement vis-à-vis de cette perturbation, et en ce que lesdits moyens de traitement comprennent des moyens pour combiner ledit signal représentatif de la perturbation au moins avec ledit signal principal ou avec un signal qui en est dérivé, pour fournir un signal corrigé représentatif dudit paramètre.

3. Dispositif suivant l'une quelconque des revendications 1 et 2, caractérisé en ce que ladite perturbation est la température.

4. Dispositif suivant l'une quelconque des revendications précédentes, caractérisé en ce que ledit second capteur (6) comprend une lame biréfringente dont la biréfringence dépend de la perturbation.

5. Dispositif suivant l'une quelconque des revendications précédentes, caractérisé en ce que ledit paramètre physique est une tension alternative.

6. Dispositif suivant l'une quelconque des revendication précédentes, caractérisé en ce que ledit premier capteur (3) comprend un cristal de germanate de bismuth $Bi_4Ge_3O_{12}$.

7. Dispositif suivant les revendications 5 et 6, caractérisé en ce que ledit premier capteur (3) présente une forme allongée terminée par deux faces planes recouvertes d'électrodes respectives dont l'une au moins est transparente pour permettre le passage de la lumière, et en ce que ladite tension alternative à mesurer est directement appliquée sur lesdites électrodes.

8. Dispositif suivant la revendication 7, caractérisé en ce que ledit cristal est orienté de manière que son axe cristallographique (0, 0, 1) soit parallèle à la direction de l'un au moins des faisceaux excitateurs.

## Claims

1. A device for measuring a changing physical parameter, the device comprising: light-emitting means (1a) suitable for producing at least one exciting light beam; a first optical sensor (3), subjected to the influence of said physical parameter, receiving at least one exciting beam (2a) and producing at least one corresponding modified beam (4a) whose polarization state depends on the value of said physical parameter; and detection means (5a, 5b, 5c) receiving at least one modified beam coming from said first sensor and producing at least one main electrical signal (Ib, Ic) dependent on said parameter, the device being characterized in that it includes a beam separator (1b) making two modified beams (4a, 4b) available, in that it further includes a second optical sensor (6) responsive to a disturbance and subjected to variations in said disturbance which, should they exist, are slower than the variations in said physical parameter, said second sensor receiving one (4b) of the two modified beams and, for the range of values of the said disturbance for which the said second sensor is active, the second sensor producing a doubly-modified beam (4c) whose polarization state depends both on said parameter and on the disturbance, in that said detection means include additional means (5d) for detecting said doubly-modified beam and for producing an additional electrical signal (Id) dependent both on said parameter and on the disturbance, and in that said device also includes processing means (7a, 7b, 8, 9, 10, 11, 12, 13) for extracting a signal representative of the disturbance by virtue of the differences between said main signal and said additional signal.

2. A device according to claim 1, characterized in that said first sensor (3) presents undesirable sensitivity to said disturbance, in that said first (3) and second (6) sensors are placed in an environment which is the same with respect to said disturbance, and in which said processing means include means for combining said signal representative of the disturbance at least with the main signal or with a signal derived therefrom in order to provide a corrected signal representative of said parameter.

3. A device according to claim 1 or 2, characterized in that said disturbance is temperature.

4. A device according to any preceding claim, characterized in that said second sensor (6) comprises a birefringent plate whose birefringence depends on the disturbance.

5. A device according to any preceding claim, characterized in that said physical parameter is an alternating voltage.

6. A device according to any preceding claim, characterized in that said first sensor comprises a crystal of bismuth germanate $Bi_4 Ge_3 O_{12}$.

7. A device according to claims 5 and 6, characterized in that said first sensor (3) is elongate in shape and is terminated by two plane faces each covered by a respective electrode with at least one of the electrodes being transparent to pass light, and in that said alternating voltage to be measured is applied directly across said electrodes.

8. A device according to claim 7, characterized in that said crystal is oriented in such a manner that its crystal axis (0, 0, 1) lies parallel to the direction of at least one of the exciting beams.

## Patentansprüche

1. Einrichtung zur Messung eines sich entwickelnden physikalischen Parameters, die Mittel (1a) zum Aussenden von Licht zur Erzeugung mindestens eines Anregungslichtstrahls, einen ersten Lichtsensor (3), der dem Einfluß des physikalischen Parameters ausgesetzt ist, mindestens einen Anregungsstrahl (2a) empfängt sowie mindestens einen entsprechend modifizierten Strahl (4a) erzeugt, dessen Polarisationszustand vom Wert des physikalischen Parameters abhängt, und Erfassungsmittel (5a, 5b, 5c) aufweist, die mindestens einen von dem ersten Sensor ausgesandten modifizierten Strahl empfangen und mindestens ein von dem Parameter abhängiges elektrisches Hauptsignal (Ib, Ic) erzeugen, dadurch gekennzeichnet, daß die Einrichtung einen Strahlteiler (Ib) enthält, durch den zwei modifizierte Strahlen (4a, 4b) verfügbar sind, daß sie weiter einen zweiten Lichtsensor (6) enthält, der auf eine Störung anspricht und Änderungen dieser Störung ausgesetzt ist, die, wenn sie auftreten, langsamer als die des physikalischen Parameters verlaufen, wobei dieser zweite Sensor einen (4b) der beiden modifizierten Strahlen empfängt und, für den Wertebereich der Störung, für den der zweite Sensor aktiv ist, einen zweimal modifizierten Strahl (4c) erzeugt, dessen Polaritätszustand von dem Parameter und der Störung abhängt, und daß die Erfassungsmittel zusätzliche Mittel (5d) zur Erfassung des zweimal modifizierten Strahls und zur Erzeugung eines elektrischen Zusatzsignals (Id) aufweisen, welches von diesem Parameter und der Störung abhängt, und daß die Einrichtung weiter Verarbeitungsmittel (7a, 7b, 8, 9, 10, 11, 12, 13) enthält, um aufgrund der Unterschiede zwischen dem Hauptsignal und dem Zusatzsignal ein die Störung darstellendes Signal abzuleiten.

2. Einrichtung nach Anspruch 1, dadurch gekennzeichnet, daß der erste Sensor (3) eine gegenüber der Störung unerwünschte Empfindlichkeit besitzt, daß der erste (3) und der zweite (6) Sensor in Bezug auf diese Störung in einer gleichen Umgebung angeordnet werden, und daß die Verarbeitungsmittel Mittel zum Kombinieren des die Störung darstellenden Signals mindestens mit dem Hauptsignal oder mit einem Signal enthalten, das davon abgeleitet ist, um ein den Parameter darstellendes korrigiertes Signal zu liefern.

3. Einrichtung nach Anspruch 1 oder 2, dadurch gekennzeichnet, daß die Störung die Temperatur ist.

4. Einrichtung nach einem beliebigen der vorherigen Ansprüche, dadurch gekennzeichnet, daß der zweite Sensor (6) eine doppelbrechende Platte ist, deren Doppelbrechung von der Störung abhängt.

5. Einrichtung nach einem beliebigen der vorherigen Ansprüche, dadurch gekennzeichnet, daß der physikalische Parameter eine Wechselspannung ist.

6. Einrichtung nach einem beliebigen der vorherigen Ansprüche, dadurch gekennzeichnet, daß der erste Sensor (3) ein Wismuthgermanatkristall $Bi_4Ge_3O_{12}$ ist.

7. Einrichtung nach den Ansprüchen 5 und 6, dadurch gekennzeichnet, daß der erste Sensor (3) eine längliche Form besitzt, die in zwei ebenen Flächen endet, welche mit entsprechenden Elektroden bedeckt sind, von denen mindestens eine transparent ist, und daß die zu messende Wechselspannung direkt an die Elektroden angelegt wird.

8. Einrichtung nach Anspruch 7, dadurch gekennzeichnet, daß der Kristall so orientiert ist, daß seine Kristallachse (0, 0, 1) parallel zur Richtung mindestens eines der Anregungsstrahlen ausgerichtet ist.

$$\underline{FIG.1}$$

$$\underline{FIG.2}$$